# EUROPEAN PATENT APPLICATION

(11) **EP 4 622 418 A1**
(43) Date of publication of application: **24.09.2025**
(21) Application number: 25163957.1
(22) Date of filing: 14.03.2025
(51) Int. Cl.: H10D 84/01, H10D 84/83

(54) **GATE CUT CONFINED WITHIN GATE TRENCH**

(30) Priority: 18.03.2024 US 202418607693
(71) Applicant: Intel Corporation, Santa Clara, CA 95054 (US)
(72) Inventor: JUN, Hwichan, Portland, 97229 (US); KOH, Shao Ming, Mountain View, 94041 (US)
(74) Representative: 2SPL Patentanwälte PartG mbB

(57) **Abstract**

Techniques are provided herein to form semiconductor devices that include one or more gate cuts that are self-aligned within the gate trench between adjacent devices. A semiconductor device includes a gate structure around or otherwise on a semiconductor region. The gate structure includes a gate dielectric and a gate electrode. The gate structure is interrupted with a gate cut that extends through an entire thickness of the gate structure and includes dielectric material to electrically isolate the portions of the gate structure on either side of the gate cut. **T**he gate cut is confined within the gate trench such that it does not extend beyond the walls of the gate trench as defined by gate spacer structures. Additionally, the gate dielectric does not extend on any surface of the gate cut, such that the gate cut directly contacts the gate electrode.

## Description

### BACKGROUND

As integrated circuits continue to scale downward in size, a number of challenges arise. For instance, reducing the size of memory and logic cells is becoming increasingly more difficult, as is reducing device spacing at the device layer. As transistors are packed more densely, the formation of certain device structures used to isolate adjacent transistors becomes challenging. Accordingly, there remain a number of non-trivial challenges with respect to forming semiconductor devices.

### BRIEF DESCRIPTION OF THE DRAWINGS

Figures 1A and 1B are cross-sectional and plan views, respectively, of some semiconductor devices that have a gate cut confined within the gate trench between the devices, in accordance with an embodiment of the present disclosure.
Figures 2A and 2B are cross-sectional and plan views that illustrate a first stage in an example process for forming semiconductor devices that have a gate cut confined within the gate trench between the devices, in accordance with some embodiments of the present disclosure.
Figures 3A and 3B are cross-sectional and plan views that illustrate another stage in the example process for forming semiconductor devices that have a gate cut confined within the gate trench between the devices, in accordance with some embodiments of the present disclosure.
Figures 4A and 4B are cross-sectional and plan views that illustrate another stage in the example process for forming semiconductor devices that have a gate cut confined within the gate trench between the devices, in accordance with some embodiments of the present disclosure.
Figures 5A and 5B are cross-sectional and plan views that illustrate another stage in the example process for forming semiconductor devices that have a gate cut confined within the gate trench between the devices, in accordance with some embodiments of the present disclosure.
Figures 6A and 6B are cross-sectional and plan views that illustrate another stage in the example process for forming semiconductor devices that have a gate cut confined within the gate trench between the devices, in accordance with some embodiments of the present disclosure.
Figures 7A and 7B are cross-sectional and plan views that illustrate another stage in the example process for forming semiconductor devices that have a gate cut confined within the gate trench between the devices, in accordance with some embodiments of the present disclosure.
Figures 8A and 8B are cross-sectional and plan views that illustrate another stage in the example process for forming semiconductor devices that have a gate cut confined within the gate trench between the devices, in accordance with some embodiments of the present disclosure.
Figures 9A and 9B are cross-sectional and plan views that illustrate another stage in the example process for forming semiconductor devices that have a gate cut confined within the gate trench between the devices, in accordance with some embodiments of the present disclosure.
Figures 10A and 10B are cross-sectional and plan views that illustrate another stage in the example process for forming semiconductor devices that have a gate cut confined within the gate trench between the devices, in accordance with some embodiments of the present disclosure.
Figures 11A and 11B are cross-sectional and plan views that illustrate another stage in the example process for forming semiconductor devices that have a gate cut confined within the gate trench between the devices, in accordance with some embodiments of the present disclosure.
Figure 12 illustrates a cross-sectional view of a chip package containing one or more semiconductor dies, in accordance with some embodiments of the present disclosure.
Figure 13 is a flowchart of a fabrication process for semiconductor devices that have a gate cut confined within the gate trench between the devices, in accordance with an embodiment of the present disclosure.
Figure 14 illustrates a computing system including one or more integrated circuits, as variously described herein, in accordance with an embodiment of the present disclosure.

Although the following Detailed Description will proceed with reference being made to illustrative embodiments, many alternatives, modifications, and variations thereof will be apparent in light of this disclosure. As will be further appreciated, the figures are not necessarily drawn to scale or intended to limit the present disclosure to the specific configurations shown. For instance, while some figures generally indicate perfectly straight lines, right angles, and smooth surfaces, an actual implementation of an integrated circuit structure may have less than perfect straight lines, right angles (e.g., some features may have tapered sidewalls and/or rounded corners), and some features may have surface topology or otherwise be non-smooth, given real world limitations of the processing equipment and techniques used.

### DETAILED DESCRIPTION

Techniques are provided herein to form semiconductor devices that include one or more gate cuts that are self-aligned within the gate trench between adjacent devices. The techniques can be used in any number of integrated circuit applications and are particularly useful with respect to device layer transistors, such as finFETs or gate-all-around transistors (e.g., ribbonFETs and nanowire FETs) or forksheet transistors (e.g., nanosheet FETs). In an example, a semiconductor device includes a gate structure around or otherwise on a semiconductor region (also referred to as a channel region). The semiconductor region can be, for example, a fin of semiconductor material that extends from a source region to a drain region, or one or more nanowires or nanoribbons or nanosheets of semiconductor material that extend from a source region to a drain region. The gate structure includes a gate dielectric (e.g., high-k gate dielectric material) and a gate electrode (e.g., conductive material such as workfunction material and/or gate fill metal). The gate structure may be interrupted, for example, between two transistors with a gate cut that extends through an entire thickness of the gate structure and includes dielectric material to electrically isolate the portions of the gate structure on either side of the gate cut. In an example, the gate cut is confined within the gate trench such that it does not extend beyond the walls of the gate trench as defined by gate spacer structures. In some examples, the gate cut includes a high k dielectric liner along an outer edge of gate cut and a relatively lower k dielectric fill. The gate cut is also formed after the formation of the gate structure, such that the gate dielectric does not form on any surface of the gate cut. Numerous variations and embodiments will be apparent in light of this disclosure.

### General Overview

As previously noted above, there remain a number of non-trivial challenges with respect to integrated circuit fabrication. In more detail, as devices become smaller and more densely packed, many structures become more challenging to fabricate as critical dimensions (CD) of the structures push the limits of current fabrication technology. Example structures like gate cuts are used in integrated circuit design to isolate gate structures from one another. Such gate cuts may be formed in various ways, but there are drawbacks to existing techniques for forming gate cuts. For example, gate cuts formed before the fabrication of the gate structures suffer from uneven heights across multiple devices on a substrate while gate cuts formed by etching trenches through multiple different materials can have a detrimental impact on the formation of other conductive features, such as source or drain contacts, which may cause poor yield.

Thus, and in accordance with an embodiment of the present disclosure, techniques are provided herein to form gate cuts through a metal gate structure that are confined within the gate trench. The configuration of the gate cuts can vary from one example to the next. In some embodiments, a gate cut includes a dielectric liner along edges of the gate cut that includes a high-k material (e.g., material with a dielectric constant greater than that of silicon dioxide which has a dielectric constant of 3.9, such as dielectrics having a dielectric constant greater than or equal to 6.5). The dielectric liner may include, for example, a conformal deposition of silicon nitride. Because the dielectric liner is along the edges of the gate cut, it may contact the gate electrode on either side of the gate cut. The gate cut also includes a dielectric fill on the dielectric liner and within an inner portion of the gate cut. According to some embodiments, the dielectric fill includes a medium-to-low-k material (e.g., material with a dielectric constant less than or equal to 4.5). Silicon dioxide or flowable silicon dioxide or porous silicon dioxide may be used for the dielectric fill, to provide a few examples. Other gate cut examples include a dielectric fill of such dielectric materials, with no liner. In any such cases, the gate cut is confined with the gate trench.

According to some embodiments, an anisotropic metal etching process may be used to etch a recess through a gate electrode between devices without significantly etching any dielectric materials. The resulting recess is confined to the gate trench (e.g., where the metal gate electrode resides). In some embodiments, any portions of the gate dielectric remaining within the recess may be removed using a suitable isotropic etching process. For instance, the gate dielectric extending along the bottom of the recess is removed, which leaves first and second ends of the gate dielectric effectively abutting the recess. One or more dielectric materials may then be deposited within the recess to form the gate cut separating the adjacent gate structures.

According to an embodiment, an integrated circuit includes a semiconductor device having a semiconductor region extending in a first direction from a source or drain region and a gate structure extending in a second direction over the semiconductor region, spacer structures on sidewalls of the gate structure and extending along the second direction with the gate structure, and a gate cut adjacent to the semiconductor device and extending along a third direction through an entire height of the gate structure. The gate structure includes a gate dielectric and a gate electrode on the gate dielectric. The gate cut extends in the first direction between the spacer structures and does not extend beyond the spacer structures. In this manner, ends of the gate cut may effectively abut the spacer structures. The gate dielectric does not extend along the sidewalls of the gate cut that extend along the first direction, although ends of the gate dielectric may also abut the sidewalls of gate cut.

According to an embodiment, an integrated circuit includes a semiconductor device having a semiconductor region extending in a first direction from a source or drain region and a gate structure extending in a second direction over the semiconductor region, spacer structures on sidewalls of the gate structure and extending along the second direction with the gate structure, and a gate cut adjacent to the semiconductor device and extending along a third direction through an entire height of the gate structure. The gate structure includes a gate dielectric and a gate electrode on the gate dielectric. The gate cut includes a first sidewall that extends along the first direction and that directly contacts the gate electrode, and the gate cut includes a second sidewall that extends along the second direction and that directly contacts one of the spacer structures.

According to another embodiment, a method of forming an integrated circuit includes forming one or more fins comprising semiconductor material, the one or more fins extending above a substrate and each extending parallel to one another in a first direction; forming a sacrificial gate extending over the semiconductor material in a second direction different from the first direction; forming spacer structures on sidewalls of the sacrificial gate; removing the sacrificial gate; forming a gate structure over the semiconductor material in the second direction and between the spacer structures; forming a recess extending across the gate electrode in the first direction and extending in a third direction through an entire height of the gate electrode, wherein a boundary of the recess along the first direction is between the spacer structures; and forming one or more dielectric materials within the recess.

The techniques can be used with any type of non-planar transistors, including finFETs (sometimes called tri-gate transistors), nanowire and nanoribbon transistors (sometimes called gate-all-around transistors), or forksheet transistors, to name a few examples. The source and drain regions can be, for example, epitaxial regions that are deposited during an etch-and-replace source/drain forming process. The dopant-type in the source and drain regions will depend on the polarity of the corresponding transistor. The gate structure can be implemented with a gate-last process (sometimes called a replacement metal gate, or RMG, process). Any number of semiconductor materials can be used in forming the transistors, such as group IV materials (e.g., silicon, germanium, silicon germanium) or group III-V materials (e.g., gallium arsenide, indium gallium arsenide).

Use of the techniques and structures provided herein may be detectable using tools such as electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. For instance, in some example embodiments, such tools may be used to detect the presence of a gate cut between devices that does not extend outside of the gate trench (e.g., remains confined within the spacer structures). In some examples, such tools may also be used to show that the gate dielectric around the semiconductor regions may abut the gate cut but does not extend up the sidewalls of the gate cut. Numerous configurations and variations will be apparent in light of this disclosure.

It should be readily understood that the meaning of "above" and "over" in the present disclosure should be interpreted in the broadest manner such that "above" and "over" not only mean "directly on" something but also include the meaning of over something with an intermediate feature or a layer therebetween. Further, spatially relative terms, such as "beneath," "below," "lower," "above," "upper," "top," "bottom," and the like, may be used herein for ease of description to describe one element or feature's relationship to another element (s) or feature (s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly.

As used herein, the term "layer" refers to a material portion including a region with a thickness. A monolayer is a layer that consists of a single layer of atoms of a given material. A layer can extend over the entirety of an underlying or overlying structure, or may have an extent less than the extent of an underlying or overlying structure. Further, a layer can be a region of a homogeneous or inhomogeneous continuous structure, with the layer having a thickness less than the thickness of the continuous structure. For example, a layer can be located between any pair of horizontal planes between, or at, a top surface and a bottom surface of the continuous structure. A layer can extend horizontally, vertically, and/or along a tapered surface. A layer can be conformal to a given surface (whether flat or curvilinear) with a relatively uniform thickness across the entire layer.

Materials that are "compositionally different" or "compositionally distinct" as used herein refers to two materials that have different chemical compositions. This compositional difference may be, for instance, by virtue of an element that is in one material but not the other (e.g., SiGe is compositionally different than silicon), or by way of one material having all the same elements as a second material but at least one of those elements is intentionally provided at a different concentration in one material relative to the other material (e.g., SiGe having 70 atomic percent germanium is compositionally different than from SiGe having 25 atomic percent germanium). In addition to such chemical composition diversity, the materials may also have distinct dopants (e.g., gallium and magnesium) or the same dopants but at differing concentrations. In still other embodiments, compositionally distinct materials may further refer to two materials that have different crystallographic orientations. For instance, (110) silicon is compositionally distinct or different from (100) silicon. Creating a stack of different orientations could be accomplished, for instance, with blanket wafer layer transfer. If two materials are elementally different, then one of the materials has an element that is not in the other material.

### Architecture

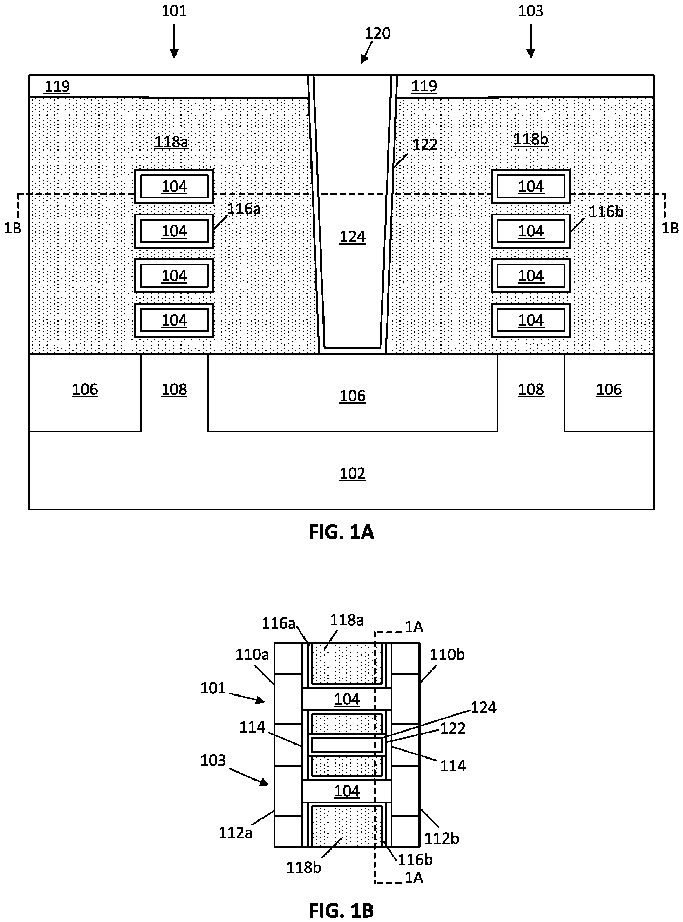

Figure 1A is a cross-sectional view taken across two example semiconductor devices 101 and 103, according to an embodiment of the present disclosure. Figure 1B is a top-down cross-section view of the adjacent semiconductor devices 101 and 103 taken across the dashed line 1B-1B depicted in Figure 1A, and Figure 1A illustrates the cross-section taken across the dashed line 1A-1A depicted in Figure 1B. It should be noted that some of the material layers (such as gate cap 119) are not visible in the top-down view of Figure 1B, given the location of the depicted cross-section. Each of semiconductor devices 101 and 103 may be non-planar metal oxide semiconductor (MOS) transistors, such as tri-gate (e.g., finFET) or gate-all-around (GAA) transistors, although other transistor topologies and types could also benefit from the gate cut techniques and structures provided herein. The illustrated example embodiments herein use the GAA structure. Semiconductor devices 101 and 103 represent a portion of an integrated circuit that may contain any number of similar semiconductor devices.

As can be seen, semiconductor devices 101 and 103 are formed on a substrate 102. Any number of semiconductor devices can be formed on substrate 102, but two are used here as an example. Substrate 102 can be, for example, a bulk substrate including group IV semiconductor material (such as silicon, germanium, or silicon germanium), group III-V semiconductor material (such as gallium arsenide, indium gallium arsenide, or indium phosphide), and/or any other suitable material upon which transistors can be formed. Alternatively, substrate 102 can be a semiconductor-on-insulator substrate having a desired semiconductor layer over a buried insulator layer (e.g., silicon over silicon dioxide). Alternatively, substrate 102 can be a multilayer substrate or superlattice suitable for forming nanowires or nanoribbons (e.g., alternating layers of silicon and SiGe, or alternating layers indium gallium arsenide and indium phosphide). Any number of substrates can be used. In some example embodiments, a lower portion of (or all of) substrate 102 is removed and replaced with one or more backside interconnect layers to form backside signal and power routing.

Each of semiconductor devices 101 and 103 includes one or more nanoribbons 104 that extend parallel to one another along a direction between a source region and a drain region (e.g., a first direction into and out of the page in the cross-section view of Figure 1A). Nanoribbons 104 are one example of semiconductor regions or semiconductor bodies that extend between source and drain regions. The term nanoribbon may also encompass other similar shapes such as nanowires or nanosheets. The semiconductor material of nanoribbons 104 may be formed from substrate 102. In some embodiments, semiconductor devices 101 and 103 may each include semiconductor regions in the shape of fins that can be, for example, native to substrate 102 (formed from the substrate itself), such as silicon fins etched from a bulk silicon substrate. Alternatively, the fins can be formed of material deposited onto an underlying substrate. In one such example case, a blanket layer of silicon germanium (SiGe) can be deposited onto a silicon substrate, and then patterned and etched to form a plurality of SiGe fins extending from that substrate. In another such example, non-native fins can be formed in a so-called aspect ratio trapping based process, where native fins are etched away so as to leave fin-shaped trenches which can then be filled with an alternative semiconductor material (e.g., group IV or III-V material). In still other embodiments, the fins include alternating layers of material (e.g., alternating layers of silicon and SiGe) that facilitates forming of the illustrated nanoribbons 104 during a gate forming process where one type of the alternating layers is selectively etched away so as to liberate the other type of alternating layers within the channel region, so that a gate-all-around (GAA) process can then be carried out. Again, the alternating layers can be blanket deposited and then etched into fins or deposited into fin-shaped trenches, according to some examples.

As can further be seen, adjacent semiconductor devices are separated by a dielectric fill 106 that may include silicon dioxide. Dielectric fill 106 provides shallow trench isolation (STI) between any adjacent semiconductor devices, and adjacent subfin regions 108. Dielectric fill 106 can be any suitable dielectric material, such as silicon dioxide, aluminum oxide, or silicon oxycarbonitride.

Semiconductor devices 101 and 103 each include a subfin region 108, in this example. According to some embodiments, subfin region 108 comprises the same semiconductor material as substrate 102 and is adjacent to dielectric fill 106. According to some embodiments, nanoribbons 104 (or other semiconductor bodies) extend between a source and a drain region in the first direction to provide an active region for a transistor (e.g., the semiconductor region beneath the gate). The source and drain regions are not shown in the cross-section of Figure 1A, but are seen in the top-down view of Figure 1B where nanoribbons 104 of semiconductor device 101 extend between a first source or drain region 110a and a second source or drain region 110b (similarly, the nanoribbons 104 of semiconductor device 103 extend between a first source or drain region 112a and a second source or drain region 112b). Figure 1B also illustrates gate spacer structures 114 that extend around the ends of nanoribbons 104 and along sidewalls of the gate structures between gate spacer structures 114. Spacer structures 114 may include a dielectric material, such as silicon nitride, and may be deposited in a conformal fashion or other suitable deposition process and be etched to a desired thickness (e.g., 2 nm to 10 nm).

According to some embodiments, the source and drain regions are epitaxial regions that are provided using an etch-and-replace process. In other embodiments one or both of the source and drain regions could be, for example, implantation-doped native portions of the semiconductor fins or substrate. Any semiconductor materials suitable for source and drain regions can be used (e.g., group IV and group III-V semiconductor materials). The source and drain regions may include multiple layers such as liners and capping layers to improve contact resistance. In any such cases, the composition and doping of the source and drain regions may be the same or different, depending on the polarity of the transistors. In an example, for instance, one transistor is a p-type MOS (PMOS) transistor, and the other transistor is an n-type MOS (NMOS) transistor. Silicon doped with phosphorous may be used for n-type source or drain regions while silicon germanium doped with boron may be used for p-type source or drain regions. Any number of source and drain configurations and materials can be used.

According to some embodiments, a first gate structure extends over nanoribbons 104 of semiconductor device 101 along a second direction across the page while a second gate structure extends over nanoribbons 104 of semiconductor device 103 along the second direction. The second direction may be orthogonal to the first direction. Each gate structure includes a respective gate dielectric 116a/116b and a gate electrode 118a/118b. Gate dielectric 116a/116b represents any number of dielectric layers present between nanoribbons 104 and gate electrode 118a/118b. Gate dielectric 116a/116b may also be present on the surfaces of other structures within the gate trench, such as on subfin region 108. Gate dielectric 116a/116b may include any suitable gate dielectric material(s). In some embodiments, gate dielectric 116a/116b includes a layer of native oxide material (e.g., silicon dioxide) on the nanoribbons or other semiconductor regions making up the channel region of the devices, and a layer of high-K dielectric material (e.g., hafnium oxide) on the native oxide.

Gate electrode 118a/118b may represent any number of conductive layers, such as any metal, metal alloy, or doped polysilicon layers. In some embodiments, gate electrode 118a/118b includes one or more workfunction metals around nanoribbons 104. In some embodiments, one of semiconductor devices 101 and 103 is a p-channel device that includes a workfunction metal having titanium around its nanoribbons 104 and the other semiconductor device is an n-channel device that includes a workfunction metal having tungsten around its nanoribbons 104. Gate electrode 118a/118b may also include a fill metal or other conductive material (e.g., tungsten, ruthenium, molybdenum, cobalt) around the workfunction metals to provide the whole gate electrode structure. In some embodiments, a gate cap 119 may be formed over gate electrode 118a/118b to protect the underlying material during processing. Gate cap 119 may be any suitable dielectric material, such as silicon nitride.

According to some embodiments, adjacent gate structures may be separated along the second direction (e.g., across the page) by a gate cut 120, which acts like a dielectric barrier or wall between gate structures. Gate cut 120 extends vertically (e.g., in a third direction) through at least an entire thickness of the adjacent gate structure. In some embodiments, gate cut 120 also extends through at least a portion of dielectric fill 106. According to some embodiments, gate cut 120 is formed from various dielectric materials. For example, gate cut 120 includes a dielectric liner 122 along an outer edge of gate cut 120 and a dielectric fill 124 on dielectric liner 122 and within an inner portion of gate cut 120. According to some embodiments, dielectric liner 122 includes a high-k dielectric material, such as silicon nitride, and dielectric fill 124 includes a medium-k or low-k dielectric material (e.g., a dielectric having a dielectric constant of about 4.5 or less), such as silicon dioxide, porous silicon dioxide, or flowable oxide. Dielectric fill 124 may also include one or more airgaps or voids, which may further lower the dielectric constant of gate cut 120. Gate cut 120 may have a top width along the second direction between about 10 nm and about 100 nm, or between about 30 nm and about 50 nm.

According to some embodiments, gate cut 120 extends in the first direction across the entire width of the gate trench as seen in Figure 1B but is confined to the gate trench. Accordingly, gate cut 120 does not extend beyond spacer structures 114 along the first direction. As will be discussed in more detail herein, gate cut 120 is formed after the formation of the gate structures, such that gate dielectric 116a/116b do not extend along the sidewalls of gate cut 120, although ends of the gate dielectric 116a/116b may abut the sidewalls of gate cut 120. Accordingly, the sidewalls of gate cut 120 that extend along the first direction may directly contact gate electrode 118a and gate electrode 118b and the sidewalls of gate cut 120 that extend along the second direction may directly contact spacer structures 114.

### Fabrication Methodology

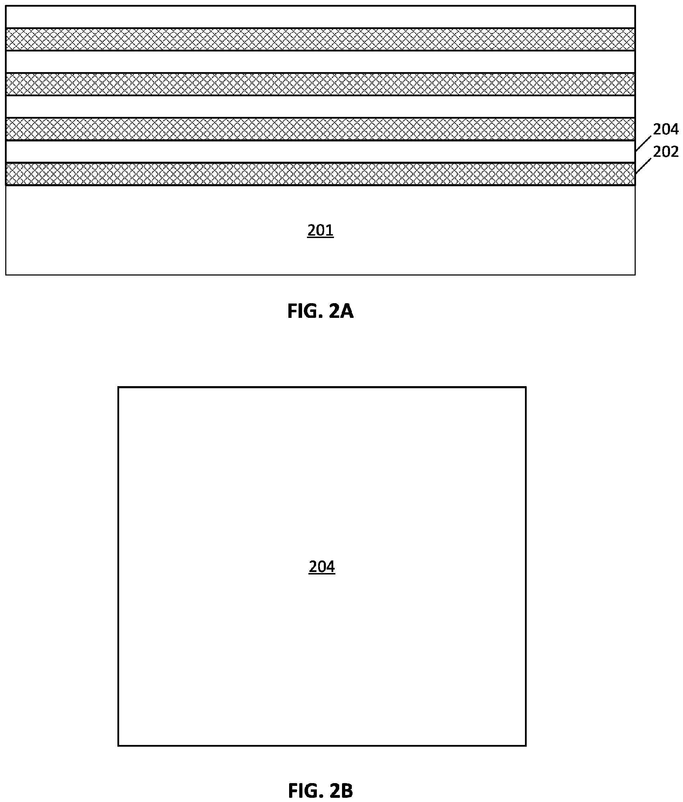

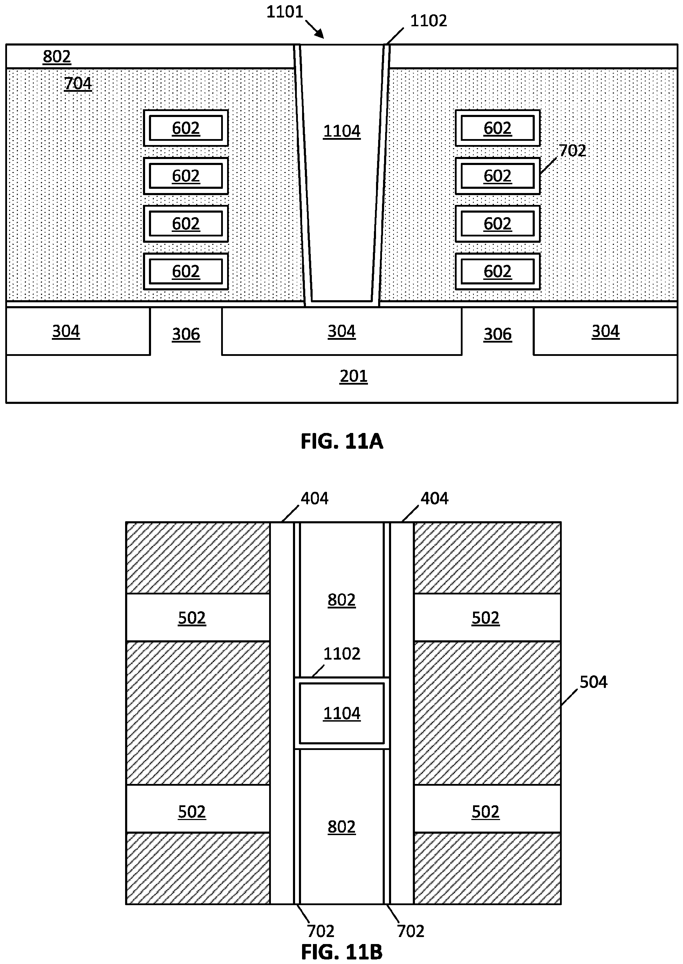

Figures 2A - 11A and 2B - 11B include cross-sectional and plan views, respectively, that collectively illustrate an example process for forming an integrated circuit with semiconductor devices that have a gate cut confined within the gate trench between the devices, in accordance with an embodiment of the present disclosure. Figures 2A - 11A represent a similar cross-sectional view as that of Figure 1A across a series of semiconductor devices, while Figures 2B - 11B represent the corresponding plan view at each stage of the fabrication. Each set of figures sharing the same letter shows an example structure that results from the process flow up to that point in time, so the depicted structure evolves as the process flow continues, culminating in the structure shown in Figures 11A - 11B, which is similar to the structure shown in Figures 1A and 1B. Such a structure may be part of an overall integrated circuit (e.g., such as a processor or memory chip) that includes, for example, digital logic cells and/or memory cells and analog mixed signal circuitry. Thus, the illustrated integrated circuit structure may be part of a larger integrated circuit that includes other integrated circuitry not depicted. Example materials and process parameters are given, but other materials and process parameters may be used as well, as will be appreciated in light of this disclosure. Although the fabrication of a single gate cut is illustrated in the aforementioned figures, it should be understood that any number of similar gate cuts can be fabricated across the integrated circuit using the same processes discussed herein.

Figures 2A and 2B illustrate a cross-sectional view taken through a substrate 201 and a plan view across substrate 201 having a series of material layers formed over the substrate, according to an embodiment of the present disclosure. Alternating material layers may be deposited over substrate 201 including sacrificial layers 202 alternating with semiconductor layers 204. The alternating layers are used to form GAA transistor structures. Any number of alternating semiconductor layers 204 and sacrificial layers 202 may be deposited over substrate 201. The description above for substrate 102 applies equally to substrate 201. The plan view of Figure 2B illustrates the topmost semiconductor layer 204 of the layer stack.

According to some embodiments, sacrificial layers 202 have a different material composition than semiconductor layers 204. In some embodiments, sacrificial layers 202 are silicon germanium (SiGe) while semiconductor layers 204 include a semiconductor material suitable for use as a nanoribbon such as silicon (Si), SiGe, germanium, or III-V materials like indium phosphide (InP) or gallium arsenide (GaAs). In examples where SiGe is used in each of sacrificial layers 202 and in semiconductor layers 204, the germanium concentration is different between sacrificial layers 202 and semiconductor layers 204. For example, sacrificial layers 202 may include a higher germanium content compared to semiconductor layers 204. In some examples, semiconductor layers 204 may be doped with either n-type dopants (to produce a p-channel transistor) or p-type dopants (to produce an n-channel transistor).

While dimensions can vary from one example embodiment to the next, the thickness of each sacrificial layer 202 may be between about 5 nm and about 20 nm. In some embodiments, the thickness of each sacrificial layer 202 is substantially the same (e.g., within 1-2 nm). The thickness of each of semiconductor layers 204 may be about the same as the thickness of each sacrificial layer 202 (e.g., about 5-20 nm). Each of sacrificial layers 202 and semiconductor layers 204 may be deposited using any known or proprietary material deposition technique, such as chemical vapor deposition (CVD), plasma-enhanced chemical vapor deposition (PECVD), physical vapor deposition (PVD), or atomic layer deposition (ALD).

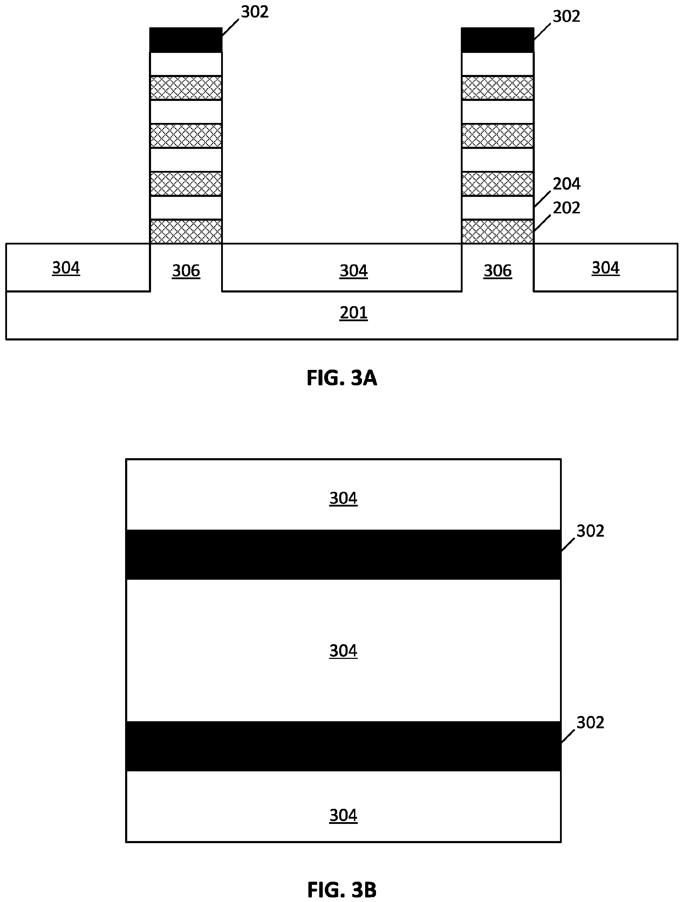

Figures 3A and 3B depict the cross-section and plan views of the structure shown in Figures 2A and 2B, respectively, following the formation of a cap layer 302 and the subsequent formation of fins beneath cap layer 302, according to an embodiment. Cap layer 302 may be any suitable hard mask material such as a carbon hard mask (CHM) or silicon nitride. Cap layer 302 is patterned into rows to form corresponding rows of fins from the alternating layer stack of sacrificial layers 202 and semiconductor layers 204. The rows of fins extend lengthwise in a first direction (e.g., into and out of the page of Figure 3A).

According to some embodiments, an anisotropic etching process through the layer stack continues into at least a portion of substrate 201. The etched portion of substrate 201 may be filled with a dielectric layer 304 that acts as shallow trench isolation (STI) between adjacent fins. Dielectric layer 304 may be any suitable dielectric material such as silicon dioxide. Subfin regions 306 represent remaining portions of substrate 201 between dielectric layer 304, according to some embodiments.

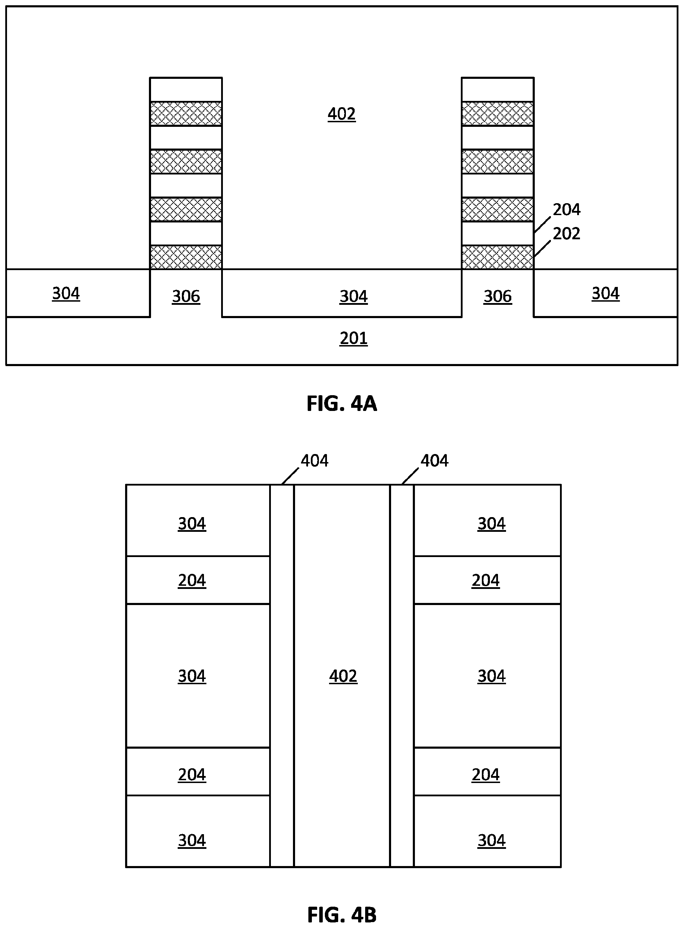

Figures 4A and 4B depict the cross-section and plan views of the structure shown in Figures 3A and 3B, respectively, following the formation of a sacrificial gate 402 extending across the fins in a second direction different from the first direction, according to some embodiments. Sacrificial gate 402 may extend across the fins in a second direction that is orthogonal to the first direction. According to some embodiments, the sacrificial gate material is formed in parallel strips across the integrated circuit and removed in all areas not protected by a gate masking layer. Sacrificial gate 402 may be any suitable material that can be selectively removed without damaging the semiconductor material of the fins. In some examples, sacrificial gate 402 includes polysilicon.

Following the formation of sacrificial gate 402, spacer structures 404 may be formed on the sidewalls of sacrificial gate 402. According to some embodiments, a dielectric material is blanket deposited across the structure and etched back to form the spacer structures 404 on the sidewalls of any structures extending above substrate 201. Spacer structures 404 extend along the sides of sacrificial gate 402 along the second direction as illustrated in Figure 4B. In some embodiments, spacer structures may also form on the sides of the fins not under sacrificial gate 402. Spacer structures 404 may be any suitable dielectric material, such as silicon nitride.

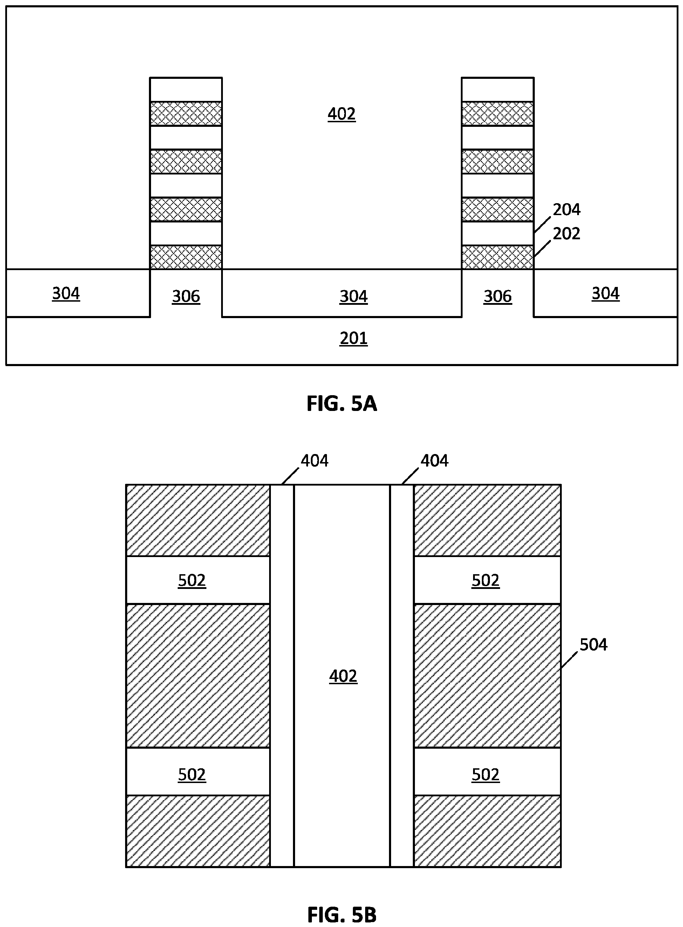

Figures 5A and 5B depict the cross-section and plan views of the structure shown in Figures 4A and 4B, respectively, following the removal of any exposed fins and the subsequent formation of source or drain regions 502 at the ends of the fins, according to some embodiments. The exposed fin portions (e.g., not protected by either sacrificial gate 402 or spacer structures 404) may be removed using any anisotropic etching process, such as reactive ion etching (RIE). The removal of the exposed fin portions creates source or drain trenches that alternate with gate trenches (currently filled with sacrificial gates 402) along the first direction, according to some embodiments.

According to some embodiments, source or drain regions 502 may be formed from the exposed ends of the fins within the source/drain trench. The source or drain regions may be formed in the areas that had been previously occupied by the exposed fins adjacent to spacer structures 404. According to some embodiments, source or drain regions 502 are epitaxially grown from the exposed semiconductor material at the ends of semiconductor layers 204. In some example embodiments, any of source or drain regions 502 can be NMOS source or drain regions (e.g., epitaxial silicon), or PMOS source or drain regions (e.g., epitaxial SiGe).

According to some embodiments, a dielectric fill 504 is provided within the source/drain trench. In some examples, dielectric fill 504 occupies a remaining volume within the source/drain trench around and possibly over source or drain regions 502. Dielectric fill 504 may be any suitable dielectric material, such as silicon dioxide. In some examples, dielectric fill 504 extends up to and planar with a top surface of spacer structures 404 (e.g., following a polishing procedure).

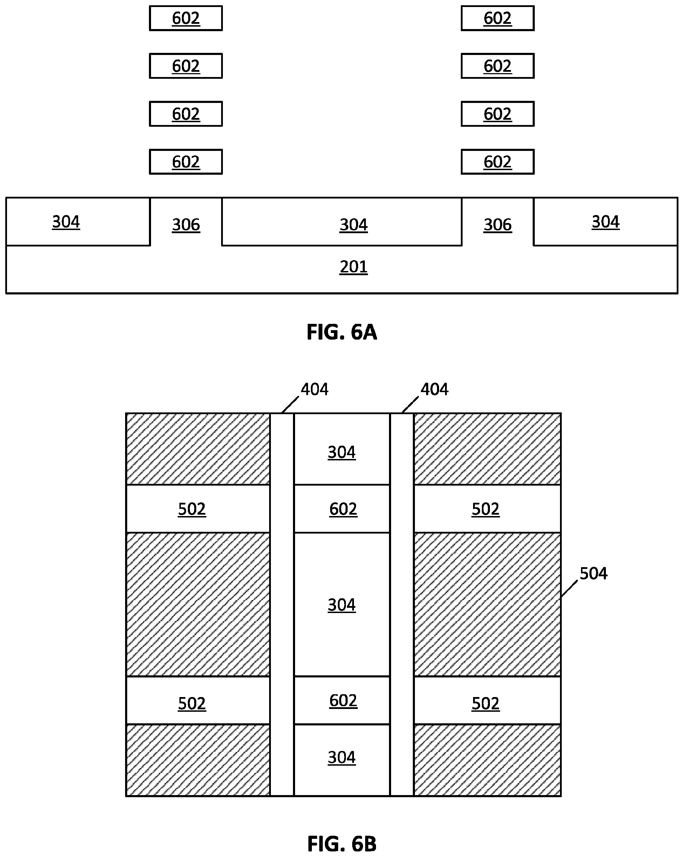

Figures 6A and 6B depict the cross-section and plan views of the structure shown in Figures 5A and 5B, respectively, following the removal of sacrificial gate 402 and the removal of sacrificial layers 202, according to some embodiments. In examples where any gate masking layers are still present, they may also be removed at this time. Once sacrificial gate 402 is removed, the fins that had been beneath sacrificial gate 402 are exposed.

In the example where the fins include alternating semiconductor layers, sacrificial layers 202 are selectively removed to release nanoribbons 602 that extend between corresponding source or drain regions 502. Each vertical set of nanoribbons 602 represents the semiconductor or channel region of a different semiconductor device. It should be understood that nanoribbons 602 may also be nanowires or nanosheets (e.g., from a forksheet arrangement) or fins (e.g., for a finFET arrangement). Sacrificial gate 402 and sacrificial layers 202 may be removed using the same isotropic etching process or different isotropic etching processes.

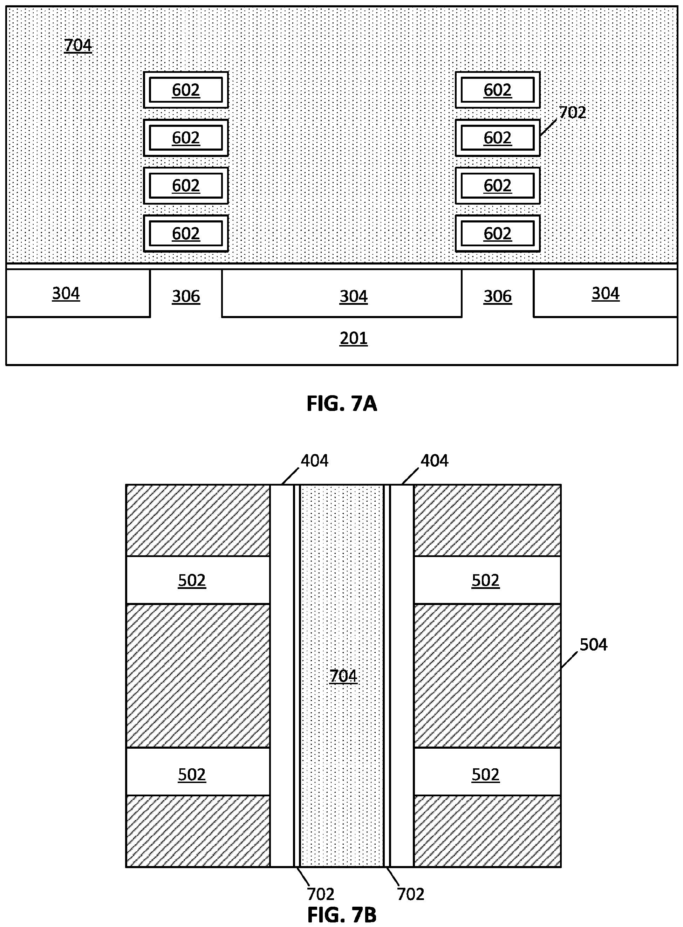

Figures 7A and 7B depict the cross-section and plan views of the structure shown in Figures 6A and 6B, respectively, following the formation of a gate structure and subsequent polishing, according to some embodiments. The gate structure includes a gate dielectric 702 and a conductive gate electrode 704. Gate dielectric 702 may be first formed around nanoribbons 602 prior to the formation of gate electrode 704. The gate dielectric 702 may include any suitable dielectric material (such as silicon dioxide, and/or a high-k dielectric material). Examples of high-k dielectric materials include, for instance, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate, to provide some examples. According to some embodiments, gate dielectric 702 includes a layer of hafnium oxide with a thickness between about 1 nm and about 5 nm. In some embodiments, gate dielectric 702 may include one or more silicates (e.g., titanium silicate, tungsten silicate, niobium silicate, and silicates of other transition metals). In some cases, gate dielectric 702 may include a first layer on nanoribbons 602, and a second layer on the first layer. The first layer can be, for instance, an oxide of the semiconductor material of nanoribbons 602 (e.g., silicon dioxide) and the second layer can be a high-k dielectric material (e.g., hafnium oxide). More generally, gate dielectric 702 can include any number of dielectric layers. According to some embodiments, gate dielectric 702 forms along all surfaces exposed within the gate trench, such as along inner sidewalls of the spacer structures (as seen in Figure 7B) and along the top surfaces of dielectric layer 304 and subfin regions 306.

As noted above, gate electrode 704 can represent any number of conductive layers. The conductive gate electrode 704 may be deposited using electroplating, electroless plating, CVD, PECVD, ALD, or PVD, to name a few examples. In some embodiments, gate electrode 704 includes doped polysilicon, a metal, or a metal alloy. Example suitable metals or metal alloys include aluminum, tungsten, cobalt, molybdenum, ruthenium, titanium, tantalum, copper, and carbides and nitrides thereof. Gate electrode 704 may include, for instance, a metal fill material along with one or more workfunction layers, resistance-reducing layers, and/or barrier layers. The workfunction layers can include, for example, p-type workfunction materials (e.g., titanium nitride) for PMOS gates, or n-type workfunction materials (e.g., titanium aluminum carbide) for NMOS gates. Following the formation of the gate structure, the entire structure may be polished or planarized such that the top surface of the gate structure (e.g., top surface of gate electrode 704) is planar with the top surface of other semiconductor elements, such as spacer structures 404 that define the gate trench.

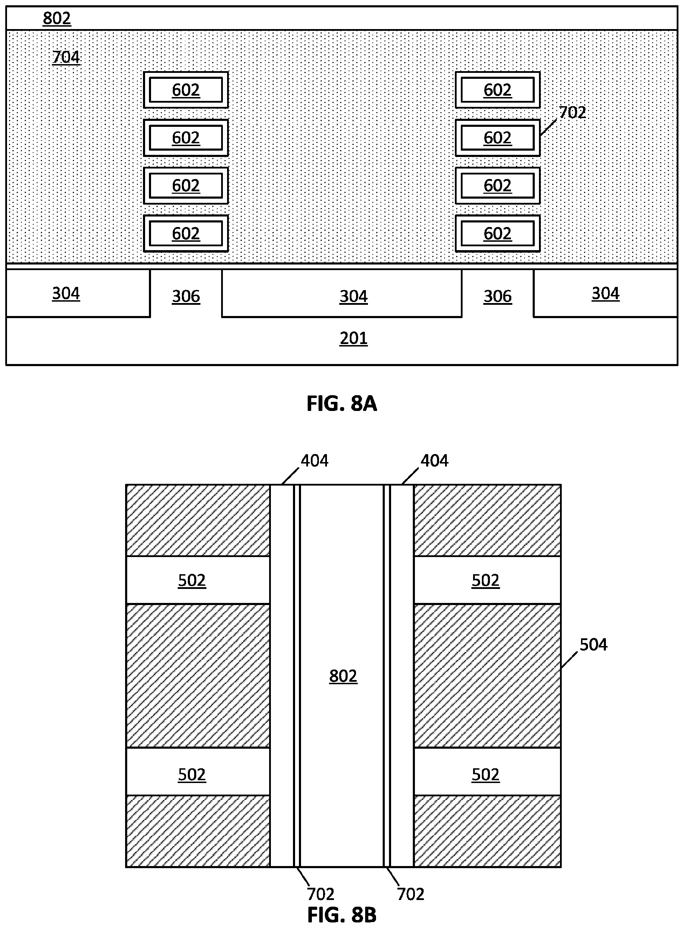

Figures 8A and 8B depict the cross-section and plan views of the structure shown in Figures 7A and 7B, respectively, following the formation of a gate cap 802, according to some embodiments. The top of gate electrode 704 may be recessed using any suitable isotropic etching process, and the recessed area within the gate trench may be subsequently filled with a dielectric material to form gate cap 802. Gate cap 802 may be any suitable dielectric material, such as silicon nitride for protecting the underlying gate electrode 704. In some examples, gate cap 802 is the same dielectric material as spacer structures 404. Note that gate dielectric 702 may be sandwiched between gate cap 802 and spacer structures 404 as seen in Figure 8B.

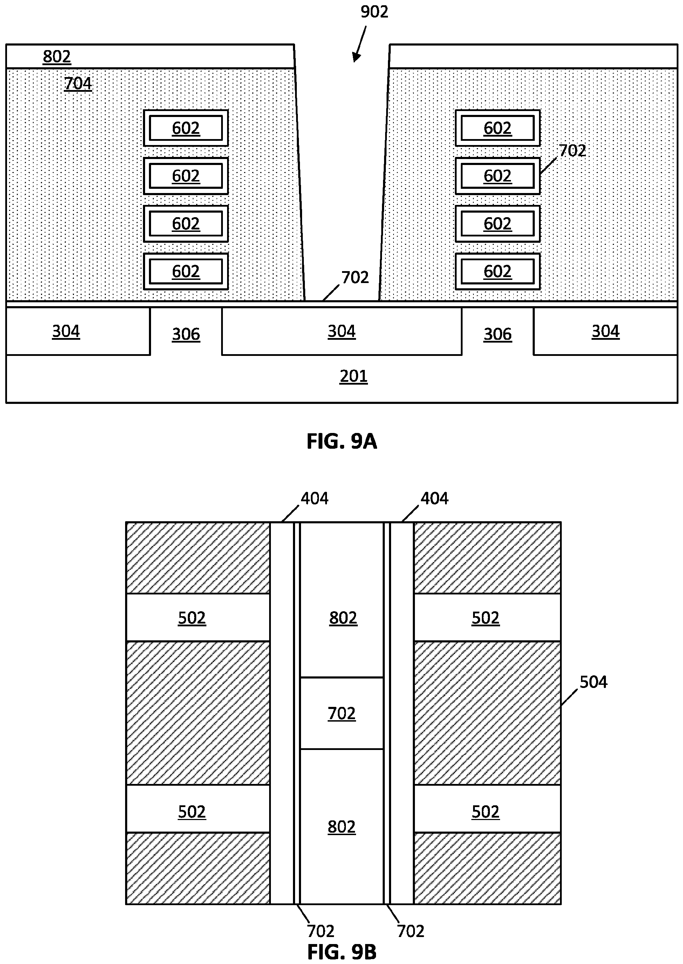

Figures 9A and 9B depict the cross-section and plan views of the structure shown in Figures 8A and 8B, respectively, following the formation of a gate cut recess 902 through at least an entire thickness of gate electrode 704, according to some embodiments. A masking structure may first be formed over gate cap 802 and patterned to form an opening through the masking structure to expose a portion of the underlying gate cap 802. The exposed portion of gate cap 802 within the opening may also be removed to expose the underlying gate electrode 704 where gate cut recess 902 will be formed. Gate cut recess 902 may have a high height-to-width aspect ratio of 5:1 or more, such as between 6:1 and 10:1 and may be formed via a series of RIE and passivation steps to etch through the conductive material of gate electrode 704. Gate cut recess 902 may be tapered and have a largest width along a top surface of gate electrode 704 between about 10 nm and about 100 nm or between about 30 nm and about 50 nm. According to some embodiments, the RIE process used to from gate cut recess 902 exhibits a high etch selectively between metal and dielectrics, such that the dielectric material of spacer structures 404, gate dielectric 702, and dielectric fill 504 are not significantly etched during the formation of gate cut recess 902. As a result, gate cut recess 902 may be confined within the gate trench as illustrated in Figure 9B.

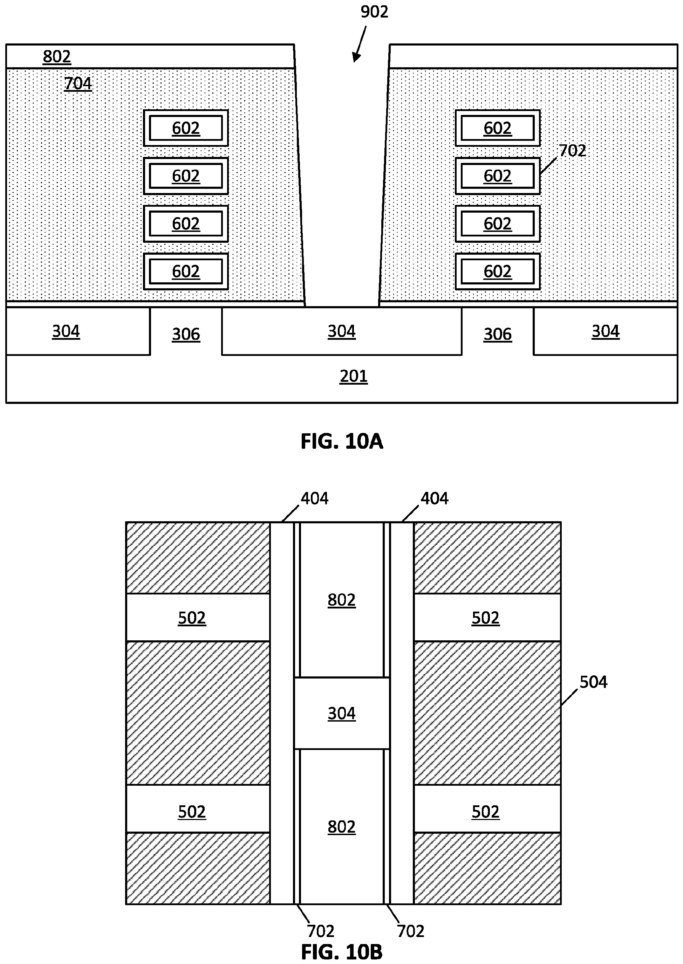

Figures 10A and 10B depict the cross-section and plan views of the structure shown in Figures 9A and 9B, respectively, following the removal of gate dielectric 702 from within gate cut recess 902, according to some embodiments. Any suitable isotropic etching process may be used to remove gate dielectric 702 from the inner sidewalls of spacer structures 404 within gate cut recess 902 and also from the bottom surface of gate cut recess 902. In some embodiments, the removal of gate dielectric 702 from the bottom of gate cut recess 902 exposes dielectric layer 304 at the bottom of gate cut recess 902. In some embodiments, a metal isotropic etch may be performed briefly to remove any remaining portions of gate electrode 704 at the bottom corners and/or edges of gate cut recess 902.

Figures 11A and 11B depict the cross-section and plan views of the structure shown in Figures 10A and 10B, respectively, following the formation of a gate cut 1101 within gate cut recess 902, according to some embodiments. Gate cut 1101 may include one or more dielectric materials within gate cut recess 902. In the illustrated example, gate cut 1101 includes a dielectric liner 1102 and a dielectric fill 1104. According to some embodiments, dielectric liner 1102 includes a high-k dielectric material, such as silicon nitride, or any other material having a dielectric constant of at least 6.5. Dielectric liner 1102 may be, for example, conformally deposited using ALD within gate cut recess 902. Dielectric fill 1104 may be formed within a remaining volume of gate cut recess 902 following the formation of dielectric liner 1102. According to some embodiments, dielectric fill 1104 includes a medium-to-low-k dielectric material, such as silicon dioxide or flowable oxide or porous oxide or any other material having a dielectric constant of 4.5 or lower, including one or more airgaps having a local dielectric constant of 1.0, to lower the overall or global dielectric constant of the dielectric gate cut structure. Dielectric fill 1104 may be deposited using any suitable plasma deposition technique, such as CVD. In still other example embodiments, dielectric fill 1104 may be conformally deposited using ALD or CVD so as to pinch-off and close at the narrow portion toward the bottom of gate cut recess 902. In some embodiments, dielectric fill 1104 pinches off at the top of gate cut recess 902 such that an airgap is formed within a central area of gate cut 1101. As seen in Figure 11B, gate cut 1101 does not extend along the first direction outside of the gate trench (e.g., does not extend beyond spacer structures 404 along the first direction). According to some embodiments, sidewalls of gate cut 1101 that extend along the first direction directly contact gate electrode 704 on either side, and sidewalls of gate cut 1101 that extend along the second direction directly contact spacer structures 404 on either side. Additionally, gate dielectric 702 does not extend up the sidewalls of gate cut 1101, such that gate cut 1101 directly contacts gate electrode 704.

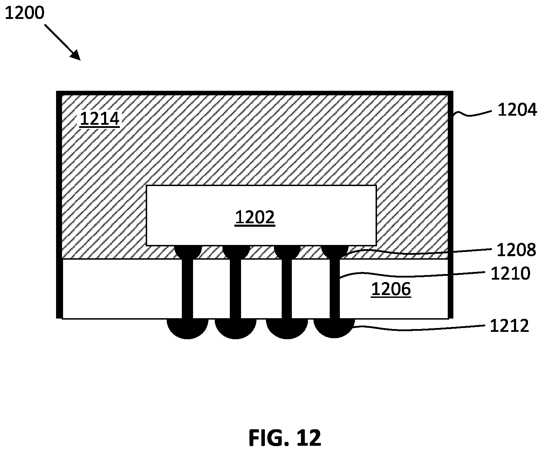

Figure 12 illustrates an example embodiment of a chip package 1200, in accordance with an embodiment of the present disclosure. As can be seen, chip package 1200 includes one or more dies 1202. One or more dies 1202 may include at least one integrated circuit having semiconductor devices, such as any of the semiconductor devices disclosed herein. One or more dies 1202 may include any other circuitry used to interface with other devices formed on the dies, or other devices connected to chip package 1200, in some example configurations.

As can be further seen, chip package 1200 includes a housing 1204 that is bonded to a package substrate 1206. The housing 1204 may be any standard or proprietary housing, and may provide, for example, electromagnetic shielding and environmental protection for the components of chip package 1200. The one or more dies 1202 may be conductively coupled to a package substrate 1206 using connections 1208, which may be implemented with any number of standard or proprietary connection mechanisms, such as solder bumps, ball grid array (BGA), pins, or wire bonds, to name a few examples. Package substrate 1206 may be any standard or proprietary package substrate, but in some cases includes a dielectric material having conductive pathways (e.g., including conductive vias and lines) extending through the dielectric material between the faces of package substrate 1206, or between different locations on each face. In some embodiments, package substrate 1206 may have a thickness less than 1 millimeter (e.g., between 0.1 millimeters and 0.5 millimeters), although any number of package geometries can be used. Additional conductive contacts 1212 may be disposed at an opposite face of package substrate 1206 for conductively contacting, for instance, a printed circuit board (PCB). One or more vias 1210 extend through a thickness of package substrate 1206 to provide conductive pathways between one or more of connections 1208 to one or more of contacts 1212. Vias 1210 are illustrated as single straight columns through package substrate 1206 for ease of illustration, although other configurations can be used (e.g., damascene, dual damascene, through-silicon via, or an interconnect structure that meanders through the thickness of substrate 1206 to contact one or more intermediate locations therein). In still other embodiments, vias 1210 are fabricated by multiple smaller stacked vias, or are staggered at different locations across package substrate 1206. In the illustrated embodiment, contacts 1212 are solder balls (e.g., for bump-based connections or a ball grid array arrangement), but any suitable package bonding mechanism may be used (e.g., pins in a pin grid array arrangement or lands in a land grid array arrangement). In some embodiments, a solder resist is disposed between contacts 1212, to inhibit shorting.

In some embodiments, a mold material 1214 may be disposed around the one or more dies 1202 included within housing 1204 (e.g., between dies 1202 and package substrate 1206 as an underfill material, as well as between dies 1202 and housing 1204 as an overfill material). Although the dimensions and qualities of the mold material 1214 can vary from one embodiment to the next, in some embodiments, a thickness of mold material 1214 is less than 1 millimeter. Example materials that may be used for mold material 1214 include epoxy mold materials, as suitable. In some cases, the mold material 1214 is thermally conductive, in addition to being electrically insulating.

### Methodology

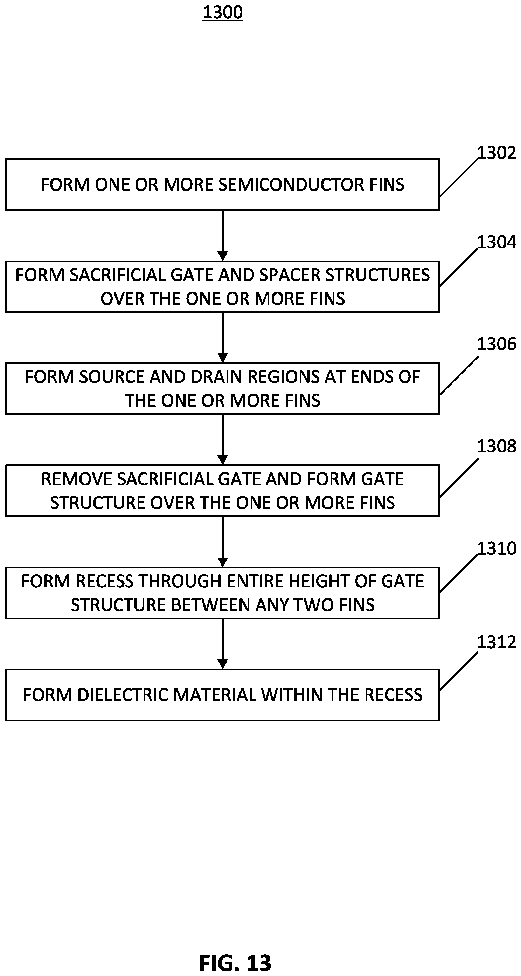

Figure 13 is a flow chart of a method 1300 for forming at least a portion of an integrated circuit, according to an embodiment. Various operations of method 1300 may be illustrated in Figures 2A - 11A and 2B - 11B. However, the correlation of the various operations of method 1300 to the specific components illustrated in the aforementioned figures is not intended to imply any structural and/or use limitations. Rather, the aforementioned figures provide one example embodiment of method 1300. Other operations may be performed before, during, or after any of the operations of method 1300. For example, method 1300 does not explicitly describe all processes that are performed to form common transistor structures. Some of the operations of method 1300 may be performed in a different order than the illustrated order.

Method 1300 begins with operation 1302 where any number of parallel semiconductor fins are formed, according to some embodiments. The semiconductor material in the fins may be formed from a substrate such that the fins are an integral part of the substrate (e.g., etched from a bulk silicon substrate). Alternatively, the fins can be formed of material deposited onto an underlying substrate. In one such example case, a blanket layer of silicon germanium (SiGe) can be deposited onto a silicon substrate, and then patterned and etched to form a plurality of SiGe fins extending from that substrate. In another such example, the fins include alternating layers of material (e.g., alternating layers of silicon and SiGe) that facilitates forming of nanowires and nanoribbons during a gate forming process where one type of the alternating layers are selectively etched away so as to liberate the other type of alternating layers within the channel region, so that a gate-all-around (GAA) process can then be carried out. The alternating layers can be blanket deposited and then etched into fins, or deposited into fin-shaped trenches. The fins may also include a cap structure over each fin that is used to define the locations of the fins during, for example, an RIE process. The cap structure may be a dielectric material, such as silicon nitride.

According to some embodiments, a dielectric layer is formed around subfin portions of the one or more fins. In some embodiments, the dielectric layer extends between each pair of adjacent parallel fins and runs lengthwise in the same direction as the fins. In some embodiments, the anisotropic etching process that forms the fins also etches into a portion of the substrate and the dielectric layer may be formed within the recessed portions of the substrate. Accordingly, the dielectric layer acts as shallow trench isolation (STI) between adjacent fins. The dielectric layer may be any suitable dielectric material, such as silicon dioxide.

Method 1300 continues with operation 1304 where a sacrificial gate and spacer structures are formed over the fins. The sacrificial gate may be patterned using a gate masking layer in a strip that runs orthogonally over the fins (many gate masking layers and corresponding sacrificial gates may be formed parallel to one another (e.g., forming a cross-hatch pattern with the fins). The gate masking layer may be any suitable hard mask material, such as CHM or silicon nitride. The sacrificial gate may be formed from any suitable material that can be selectively removed at a later time without damaging the semiconductor material of the fins. In one example, the sacrificial gate includes polysilicon. The spacer structures may be deposited and then etched back such that the spacer structures remain mostly only on sidewalls of any exposed structures. According to some embodiments, the spacer structures may be any suitable dielectric material, such as silicon nitride or silicon oxynitride.

Method 1300 continues with operation 1306 where source or drain regions are formed at the ends of the semiconductor regions of each of the fins. Any portions of the fins not protected by the sacrificial gate and spacer structures may be removed using, for example, an anisotropic etching process followed by the epitaxial growth of the source or drain regions from the exposed ends of the semiconductor layers in the fins. In some example embodiments, the source or drain regions are NMOS source or drain regions (e.g., epitaxial silicon) or PMOS source or drain regions (e.g., epitaxial SiGe). Another dielectric fill may be formed adjacent to the various source or drain regions for additional electrical isolation between adjacent regions. The dielectric fill may also extend over a top surface of the source or drain regions. In some embodiments, topside conductive contacts may be formed through the dielectric fill to contact one or more of the source or drain regions.

Method 1300 continues with operation 1308 where the sacrificial gate is removed and replaced with a gate structure. The sacrificial gate may be removed using an isotropic etching process that selectively removes all of the material from the sacrificial gate, thus exposing the various fins between the set of spacer structures. In the example case where GAA transistors are used, any sacrificial layers within the exposed fins between the spacer structures may also be removed to release nanoribbons, nanosheets, or nanowires of semiconductor material.

The gate structure may include both a gate dielectric and a gate electrode. The gate dielectric is first formed over the exposed semiconductor regions between the spacer structures followed by forming the gate electrode within the remainder of the trench between the spacer structures, according to some embodiments. The gate dielectric may include any number of dielectric layers deposited using a CVD process, such as ALD. The gate electrode can include any number of conductive material layers, such as any metals, metal alloys, or polysilicon. The gate electrode may be deposited using electroplating, electroless plating, CVD, ALD, PECVD, or PVD, to name a few examples. In some embodiments, the gate electrode may be recessed, and a dielectric gate cap is formed within the recessed area. The dielectric gate cap may have a thickness, for instance, between 10 nm and 20 nm, such as around 15 nm.

Method 1300 continues with operation 1310 where a recess is formed through an entire thickness of the gate structure. A mask structure may be formed over the gate structure and an opening may be formed through the mask structure (and the gate cap, if present) to expose a portion of the underlying gate electrode. According to some embodiments, the opening through the mask structure is at a location where the recess is to be formed through the underlying gate electrode. The mask structure may include any number of hard mask layers, such as any dielectric layers or carbon hard mask layers. The opening may be formed using a directional RIE process. According to some embodiments, the recess through the gate electrode extends through at least an entire thickness of the gate electrode such that the recess terminates at the gate dielectric at the bottom of the gate trench. According to some embodiments, a selective anisotropic RIE process is used to form the recess, such that the metal material of the gate electrode is removed while removing little to none of any exposed dielectric materials, such as the dielectric material from the spacer structures. As a result, the recess is confined within the gate trench (e.g., does not extend past the spacer structures along the first direction), according to some embodiments. Following the anisotropic metal etching process, an isotropic etching process may be performed to remove any exposed portions of the gate dielectric within the recess.

Method 1300 continues with operation 1312 where dielectric material is formed within the recess to form a gate cut. In some embodiments, a single high-k dielectric material, such as silicon nitride, is used to fill the recess. In some embodiments, the gate cut includes a dielectric liner formed first within the recess and a dielectric fill formed on the dielectric liner. According to some embodiments, the dielectric liner includes a high-k dielectric material, such as silicon nitride, deposited using ALD. According to some embodiments, the dielectric fill includes a medium-to-low-k dielectric material, such as silicon dioxide or flowable oxide or any other material having a dielectric constant of 4.5 or lower, as described above. The dielectric fill may be polished back until a top surface of the dielectric fill is level with a top surface of the spacer structures and/or a top surface of the gate cap on the gate electrode. Due to the confinement of the recess within the gate trench, the resulting gate cut is also confined within the gate trench, such that it does not extend beyond the spacer structures along the first direction. Furthermore, since the gate cut is formed after the formation of the gate structure, the gate dielectric is not formed along sidewalls of the gate cut.

### Example System

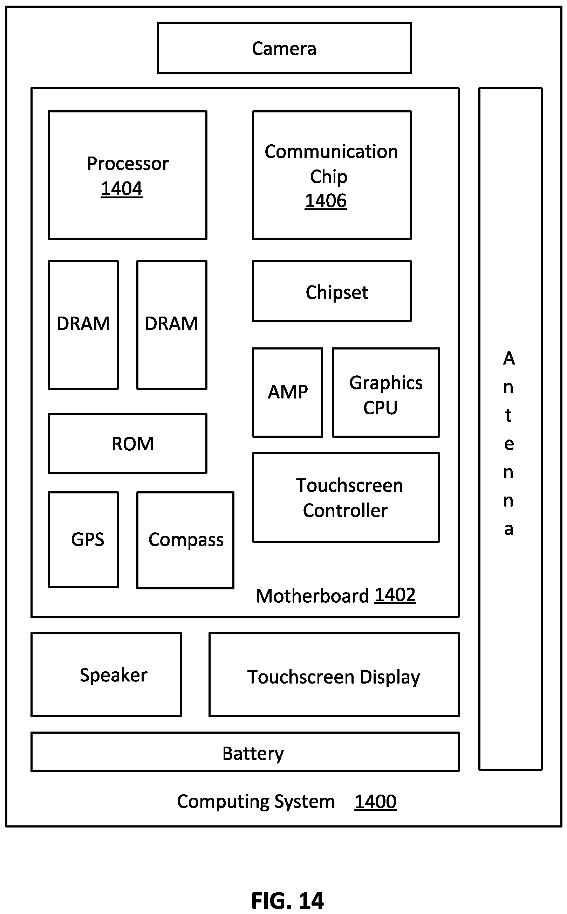

FIG. 14 is an example computing system implemented with one or more of the integrated circuit structures as disclosed herein, in accordance with some embodiments of the present disclosure. As can be seen, the computing system 1400 houses a motherboard 1402. The motherboard 1402 may include a number of components, including, but not limited to, a processor 1404 and at least one communication chip 1406, each of which can be physically and electrically coupled to the motherboard 1402, or otherwise integrated therein. As will be appreciated, the motherboard 1402 may be, for example, any printed circuit board (PCB), whether a main board, a daughterboard mounted on a main board, or the only board of system 1400, etc.

Depending on its applications, computing system 1400 may include one or more other components that may or may not be physically and electrically coupled to the motherboard 1402. These other components may include, but are not limited to, volatile memory (e.g., DRAM), non-volatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 1400 may include one or more integrated circuit structures or devices configured in accordance with an example embodiment, such as a module including an integrated circuit on a substrate, the substrate having semiconductor devices include one or more gate cuts that are self-aligned within the gate trench between adjacent devices. In some embodiments, multiple functions can be integrated into one or more chips (e.g., for instance, note that the communication chip 1406 can be part of or otherwise integrated into the processor 1404).

The communication chip 1406 enables wireless communications for the transfer of data to and from the computing system 1400. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 1406 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 1400 may include a plurality of communication chips 1406. For instance, a first communication chip 1406 may be dedicated to shorter range wireless communications such as Wi-Fi and Bluetooth and a second communication chip 1406 may be dedicated to longer range wireless communications such as GPS, EDGE, GPRS, CDMA, WiMAX, LTE, Ev-DO, and others.

The processor 1404 of the computing system 1400 includes an integrated circuit die packaged within the processor 1404. In some embodiments, the integrated circuit die of the processor includes onboard circuitry that is implemented with one or more semiconductor devices as variously described herein. The term "processor" may refer to any device or portion of a device that processes, for instance, electronic data from registers and/or memory to transform that electronic data into other electronic data that may be stored in registers and/or memory.

The communication chip 1406 also may include an integrated circuit die packaged within the communication chip 1406. In accordance with some such example embodiments, the integrated circuit die of the communication chip includes one or more semiconductor devices as variously described herein. As will be appreciated in light of this disclosure, note that multistandard wireless capability may be integrated directly into the processor 1404 (e.g., where functionality of any chips 1406 is integrated into processor 1404, rather than having separate communication chips). Further note that processor 1404 may be a chip set having such wireless capability. In short, any number of processor 1404 and/or communication chips 1406 can be used. Likewise, any one chip or chip set can have multiple functions integrated therein.

In various implementations, the computing system 1400 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device that processes data or employs one or more integrated circuit structures or devices formed using the disclosed techniques, as variously described herein.

It will be appreciated that in some embodiments, the various components of the computing system 1400 may be combined or integrated in a system-on-a-chip (SoC) architecture. In some embodiments, the components may be hardware components, firmware components, software components or any suitable combination of hardware, firmware or software.

### Further Example Embodiments

The following examples pertain to further embodiments, from which numerous permutations and configurations will be apparent.

Example 1 is an integrated circuit that includes a semiconductor device having a semiconductor region extending in a first direction from a source or drain region and a gate structure extending in a second direction over the semiconductor region, spacer structures on sidewalls of the gate structure and extending along the second direction with the gate structure, and a gate cut adjacent to the semiconductor device and extending along a third direction through an entire height of the gate structure. The gate structure includes a gate dielectric and a gate electrode on the gate dielectric. The gate cut extends in the first direction between the spacer structures and does not extend beyond the spacer structures. In this manner, ends of the gate cut may effectively abut the spacer structures. The gate dielectric does not extend along the sidewalls of the gate cut that extend along the first direction, although ends of the gate dielectric may also abut the sidewalls of gate cut.

Example 2 includes the integrated circuit of Example 1, wherein the gate cut comprises silicon and nitrogen.

Example 3 includes the integrated circuit of Example 1 or 2, wherein the gate cut comprises a dielectric liner and a dielectric fill on the dielectric liner.

Example 4 includes the integrated circuit of Example 3, wherein the dielectric liner comprises silicon and nitrogen, and the dielectric fill comprises silicon and oxygen.

Example 5 includes the integrated circuit of any one of Examples 1-4, wherein an end of the gate dielectric abuts a sidewall of the gate cut that extends along the first direction.

Example 6 includes the integrated circuit of Example 5, wherein the end is a first end of the gate dielectric, and wherein a second end of the gate dielectric abuts the sidewall of the gate cut.

Example 7 includes the integrated circuit of any one of Examples 1-6, wherein the gate electrode directly contacts the sidewall of the gate cut.

Example 8 includes the integrated circuit of any one of Examples 1-7, wherein the sidewall of the gate cut is a first sidewall, and wherein a second sidewall of the gate cut that extends along the second direction directly contacts one of the spacer structures.

Example 9 includes the integrated circuit of any one of Examples 1-8, wherein a width at a top surface of the gate cut along the second direction is between about 25 nm and about 50 nm.

Example 10 includes the integrated circuit of any one of Examples 1-9, wherein the semiconductor region comprises a plurality of semiconductor nanoribbons.

Example 11 includes the integrated circuit of Example 10, wherein the plurality of semiconductor nanoribbons comprise germanium, silicon, or a combination thereof.

Example 12 is a printed circuit board comprising the integrated circuit of any one of Examples 1-11.

Example 13 is an electronic device that includes a chip package having one or more dies. At least one of the one or more dies includes a semiconductor region extending in a first direction from a source or drain region, a gate structure extending in a second direction over the semiconductor region, spacer structures on sidewalls of the gate structure and extending along the second direction with the gate structure, and a gate cut adjacent to the semiconductor region and extending along a third direction through an entire height of the gate structure. The gate structure includes a gate dielectric and a gate electrode on the gate dielectric. The gate cut extends in the first direction between the spacer structures and does not extend beyond the spacer structures. An end of the gate dielectric abuts a sidewall of the gate cut that extends along the first direction, and the gate dielectric does not extend along the sidewall of the gate cut in the third direction.

Example 14 includes the electronic device of Example 13, wherein the gate cut comprises silicon and nitrogen.

Example 15 includes the electronic device of Example 13 or 14, wherein the gate cut comprises a dielectric liner and a dielectric fill on the dielectric liner.

Example 16 includes the electronic device of Example 15, wherein the dielectric liner comprises silicon and nitrogen, and the dielectric fill comprises silicon and oxygen.

Example 17 includes the electronic device of any one of Examples 13-16, wherein the gate electrode directly contacts the sidewall of the gate cut.

Example 18 includes the electronic device of any one of Examples 13-17, wherein the sidewall of the gate cut is a first sidewall, and wherein a second sidewall of the gate cut that extends along the second direction directly contacts one of the spacer structures.

Example 19 includes the electronic device of any one of Examples 13-18, wherein a width at a top surface of the gate cut along the second direction is between about 25 nm and about 50 nm.

Example 20 includes the electronic device of any one of Examples 13-19, wherein the semiconductor region comprises a plurality of semiconductor nanoribbons.

Example 21 includes the electronic device of Example 20, wherein the plurality of semiconductor nanoribbons comprise germanium, silicon, or a combination thereof.

Example 22 includes the electronic device of any one of Examples 13-21, further comprising a printed circuit board, wherein the chip package is coupled to the printed circuit board.

Example 23 is a method of forming an integrated circuit. The method includes forming one or more fins comprising semiconductor material, the one or more fins extending above a substrate and each extending parallel to one another in a first direction, forming a sacrificial gate extending over the semiconductor material in a second direction different from the first direction, forming spacer structures on sidewalls of the sacrificial gate, removing the sacrificial gate, forming a gate structure over the semiconductor material in the second direction and between the spacer structures, forming a recess extending across the gate structure in the first direction and extending in a third direction through an entire height of the gate structure, wherein a boundary of the recess along the first direction is between the spacer structures, and forming one or more dielectric materials within the recess.

Example 24 includes the method of Example 23, wherein forming the gate structure comprises forming a gate dielectric and forming a gate electrode on the gate dielectric.

Example 25 includes the method of Example 24, further comprising removing exposed portions of the gate dielectric within the recess.

Example 26 includes the method of Example 24 or 25, wherein forming the recess comprises using a reactive ion etching (RIE) process to remove the gate electrode while removing substantially none of the gate dielectric and the spacer structures.

Example 27 includes the method of any one of Examples 24-26, wherein forming the gate dielectric comprises forming a high-k dielectric layer.

Example 28 includes the method of any one of Examples 23-27, wherein forming the one or more dielectric materials comprises forming a dielectric liner and forming a dielectric fill on the dielectric liner.

Example 29 is an integrated circuit that includes a semiconductor device having a semiconductor region extending in a first direction from a source or drain region and a gate structure extending in a second direction over the semiconductor region, spacer structures on sidewalls of the gate structure and extending along the second direction with the gate structure, and a gate cut adjacent to the semiconductor device and extending along a third direction through an entire height of the gate structure. The gate structure includes a gate dielectric and a gate electrode on the gate dielectric. The gate cut includes a first sidewall that extends along the first direction and that directly contacts the gate electrode, and the gate cut includes a second sidewall that extends along the second direction and that directly contacts one of the spacer structures.

Example 30 includes the integrated circuit of Example 29, wherein the gate cut comprises silicon and nitrogen.

Example 31 includes the integrated circuit of Example 29 or 30, wherein the gate cut comprises a dielectric liner and a dielectric fill on the dielectric liner.

Example 32 includes the integrated circuit of Example 31, wherein the dielectric liner comprises silicon and nitrogen, and the dielectric fill comprises silicon and oxygen.

Example 33 includes the integrated circuit of any one of Examples 29-32, wherein an end of the gate dielectric abuts the first sidewall of the gate cut.

Example 34 includes the integrated circuit of Example 36, wherein the gate dielectric does not extend along the first sidewall of the gate cut in the third direction.

Example 35 includes the integrated circuit of any one of Examples 29-34, wherein the gate cut does not extend beyond the spacer structures along the first direction.

Example 36 includes the integrated circuit of any one of Examples 29-35, wherein a width at a top surface of the gate cut along the second direction is between about 25 nm and about 50 nm.

Example 37 includes the integrated circuit of any one of Examples 29-36, wherein the semiconductor region comprises a plurality of semiconductor nanoribbons.

Example 38 includes the integrated circuit of Example 37, wherein the plurality of semiconductor nanoribbons comprise germanium, silicon, or a combination thereof.

Example 39 is a printed circuit board comprising the integrated circuit of any one of Examples 29-38.

The foregoing description of the embodiments of the disclosure has been presented for the purposes of illustration and description. It is not intended to be exhaustive or to limit the disclosure to the precise forms disclosed. Many modifications and variations are possible in light of this disclosure. It is intended that the scope of the disclosure be limited not by this detailed description, but rather by the claims appended hereto.

## Claims

1. An integrated circuit comprising:
a source or drain region;
a semiconductor region extending in a first direction from the source or drain region;
a gate structure extending in a second direction over the semiconductor region, the gate structure comprising a gate dielectric and a gate electrode on the gate dielectric;
spacer structures on sidewalls of the gate structure and extending along the second direction; and
a gate cut extending along a third direction through an entire height of the gate structure, wherein the gate cut extends in the first direction between the spacer structures and does not extend beyond the spacer structures, and wherein the gate dielectric is not present on a sidewall of the gate cut that extends along the first direction.

2. The integrated circuit of claim 1, wherein the gate cut comprises silicon and nitrogen.

3. The integrated circuit of claim 1 or 2, wherein the gate cut comprises a dielectric liner and a dielectric fill on the dielectric liner.

4. The integrated circuit of claim 3, wherein the dielectric liner comprises silicon and nitrogen, and the dielectric fill comprises silicon and oxygen.

5. The integrated circuit of any one of claims 1 through 4, wherein an end of the gate dielectric abuts a sidewall of the gate cut that extends along the first direction.

6. The integrated circuit of claim 5, wherein the end is a first end of the gate dielectric, and wherein a second end of the gate dielectric abuts the sidewall of the gate cut.

7. The integrated circuit of any one of claims 1 through 6, wherein the gate electrode directly contacts the sidewall of the gate cut.

8. The integrated circuit of any of claims 1 through 7, wherein the sidewall of the gate cut is a first sidewall, and wherein a second sidewall of the gate cut that extends along the second direction directly contacts one of the spacer structures.

9. The integrated circuit of any of claims 1 through 8, wherein a width at a top surface of the gate cut along the second direction is between about 25 nm and about 50 nm.

10. The integrated circuit of any of claims 1 through 9, wherein the semiconductor region comprises a plurality of semiconductor nanoribbons.

11. The integrated circuit of claim 10, wherein the plurality of semiconductor nanoribbons comprise germanium, silicon, or a combination thereof.

12. A printed circuit board comprising the integrated circuit of any of claims 1 through 11.

13. A method of forming an integrated circuit, the method comprising:
forming one or more fins comprising semiconductor material, the one or more fins extending above a substrate and each extending parallel to one another in a first direction;
forming a sacrificial gate extending over the semiconductor material in a second direction different from the first direction;
forming spacer structures on sidewalls of the sacrificial gate;
removing the sacrificial gate;
forming a gate structure over the semiconductor material in the second direction and between the spacer structures;
forming a recess extending across the gate structure in the first direction and extending in a third direction through an entire height of the gate structure, wherein a boundary of the recess along the first direction is between the spacer structures; and
forming one or more dielectric materials within the recess.

14. The method of claim 13, wherein forming the recess comprises using a reactive ion etching (RIE) process to remove the gate electrode while removing substantially none of the gate dielectric and the spacer structures.

15. The method of claim 13 or 14, wherein forming the one or more dielectric materials comprises forming a dielectric liner and forming a dielectric fill on the dielectric liner.
